(19) Europäisches Patentamt
European Patent Office
Office européen des brevets

(11) **EP 3 161 958 B1**

(12) **FASCICULE DE BREVET EUROPEEN**

(45) Date de publication et mention
de la délivrance du brevet:
**24.02.2021 Bulletin 2021/08**

(21) Numéro de dépôt: **15731971.6**

(22) Date de dépôt: **30.06.2015**

(51) Int Cl.:
**H03F 3/181** *(2006.01)*    **H03F 3/217** *(2006.01)*

(86) Numéro de dépôt international:
**PCT/EP2015/064895**

(87) Numéro de publication internationale:
**WO 2016/001253 (07.01.2016 Gazette 2016/01)**

(54) **AMPLIFICATEUR AUDIO TRÈS HAUTE FIDÉLITÉ**

TONVERSTÄRKER MIT SEHR HOHER WIEDERGABETREUE

VERY HIGH FIDELITY AUDIO AMPLIFIER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.06.2014 FR 1456208**

(43) Date de publication de la demande:
**03.05.2017 Bulletin 2017/18**

(73) Titulaire: **Devialet**
**75001 Paris (FR)**

(72) Inventeur: **CALMEL, Pierre-Emmanuel**
**F-78150 Le Chesnay (FR)**

(74) Mandataire: **Lavoix**
**2, place d'Estienne d'Orves**
**75441 Paris Cedex 09 (FR)**

(56) Documents cités:
WO-A1-2004/057754    WO-A1-2011/107669
FR-A1- 2 828 582      GB-A- 434 632
JP-A- S57 171 809     US-A1- 2011 050 363

• NAM-IN KIM ET AL: "Ripple feedback filter suitable for analog/digital mixed-mode audio amplifier for improved efficiency and stability", POWER ELECTRONICS SPECIALISTS CONFERENCE; [ANNUAL POWER ELECTRONICS SPECIALISTS CONFERENCE],, vol. 1, 23 juin 2002 (2002-06-23), pages 45-49, XP010596063, ISBN: 978-0-7803-7262-7
• DARDILLAC S ET AL: "Highly selective planar filter using negative resistances for loss compensation", MICROWAVE CONFERENCE, 2003. 33RD EUROPEAN 7-9 OCT. 2003, PISCATAWAY, NJ, USA,IEEE, vol. 2, 7 octobre 2003 (2003-10-07), pages 821-824, XP010681021, ISBN: 978-1-58053-835-0

EP 3 161 958 B1

## Description

La présente invention concerne un amplificateur audio haute-fidélité à faible distorsion et haut rendement

La demande de brevet WO-2011/107 669 décrit le couplage d'un amplificateur analogique classe A, formé d'un générateur de tension de référence et d'un amplificateur numérique classe D constituant un générateur de tension de puissance, lequel est couplé à la sortie du générateur de tension de référence par une inductance, avec laquelle il forme alors une source de courant.

L'association d'un amplificateur classe A et d'un amplificateur classe D a pour but de créer un amplificateur de très fort rendement et de très haute linéarité.

En pratique, plusieurs phénomènes limitent le rendement total d'un tel amplificateur, sa capacité à reproduire les hautes fréquences, et sa puissance maximale atteignable. Ces phénomènes sont notamment les suivants.

Les pertes de commutation des transistors MOS de l'amplificateur classe D soumis à une commande PWM sont proportionnelles à la fréquence de commutation. Pour cette raison, en pratique, cette fréquence ne peut pas dépasser significativement 500 kHz pour des tensions supérieures à 100 volts. Du fait de la commande PWM et du fait de l'aspect inductif de l'impédance de couplage, une ondulation triangulaire de courant (ou ripple current en anglais) est formée dans l'impédance de couplage.

L'amplitude de l'ondulation triangulaire dans l'impédance de l'amplificateur classe D est inversement proportionnelle à la fréquence de commutation et inversement proportionnelle à la valeur de l'inductance. Mais pour être capable de reproduire le haut du spectre audio, l'inductance utilisée doit être de faible valeur de manière à ne pas limiter la vitesse de variation du courant (current slew rate en anglais) dans la bande audio. Malheureusement, cette valeur faible d'inductance conduit à une amplitude de courant triangulaire à la fréquence de commutation du classe D de forte valeur. Or, ce courant triangulaire haute fréquence est totalement absorbé et dissipé par l'amplificateur analogique classe A, ce qui provoque une dissipation thermique importante.

Dans ces conditions, l'amplificateur classe A est très sollicité lors de la reproduction de hautes fréquences notamment supérieures à 10 kHz.

Il existe deux solutions connues pour diminuer ou annuler le ripple haute fréquence des amplificateurs classe D.

Une première solution consiste en l'utilisation d'un circuit bouchon (RLC) accordé sur la fréquence de fonctionnement de la commande PWM du classe D. Ce circuit bouchon étant placé à la sortie de l'amplificateur alimentant la charge.

Cette solution présente deux inconvénients, à savoir l'annulation seulement du fondamental du courant triangulaire haute fréquence et l'introduction d'un déphasage affectant les harmoniques du signal, qui nuit fortement à la stabilité de l'asservissement de la boucle de contrôle.

La seconde solution consiste en l'utilisation d'une technique dite de « Ripple Steering » et décrite dans les publications AES Society. Cette technique est basée sur deux hypothèses structurelles fortes, à savoir :

    o un fonctionnement obligatoire en bridge de deux amplificateurs classe D, la charge n'étant pas connectée à la masse, et

    o un fonctionnement en opposition de phase des deux amplificateurs classe D.

Ces hypothèses sont souvent non souhaitées dans un amplificateur.

On connaît par ailleurs par l'amplificateur D-Premier, commercialisé par la société Devialet, lequel a recours en tant qu'impédance de couplage à deux inductances montées en série et dont le point milieu est relié à la masse par une résistance. Cette résistance a pour but d'absorber l'énergie très haute fréquence (dans une bande de fréquence supérieure à 20MHz) due à la commutation des ponts de transistors MOS présents dans l'amplificateur classe D et ne contribue pas à la ripple du courant triangulaire.

WO 2004/057754, FR 2 828 582 A1 NAM-IN KIM ET AL: "Ripple feedback filter suitable for analog/digital mixed-mode audio amplifier for improved efficiency and stability",POWER ELECTRONICS SPECIALISTS CONFERENCE; [ANNUAL POWER ELECTRONICS SPECIALISTS CONFERENCE],, vol. 1, 23 juin 2002 (2002-06-23), pages 45-49, ISBN: 978-0-7803-7262-7 et JP S57 171809 décrivent chacun un étal de la technique.

L'invention a pour but d'améliorer le ratio de courant fourni par l'amplificateur classe A sur le courant fourni par l'amplificateur classe D pour des fréquences élevées, permettant ainsi de réduire l'échauffement de l'amplificateur classe A tout en augmentant la bande passante utile et la linéarité du système.

A cet effet, l'invention a pour objet un amplificateur audio selon la revendication 1.

Suivant des modes particuliers de réalisation, l'amplificateur comporte l'une ou plusieurs des caractéristiques des revendications dépendantes.

L'invention sera mieux comprise à la lecture de la description qui va suivre, donnée uniquement à titre d'exemple et faite en se référant aux dessins sur lesquels :

- la figure 1 est un schéma électrique d'un amplificateur audio haute-fidélité à faible distorsion et très haut rendement selon un premier mode de réalisation de l'invention ;

- la figure 2 est une échelle de fréquence explicitant les différentes zones de fonctionnement de l'amplificateur ;

- la figure 3 est un graphe d'une fonction de transfert ; et
- la figure 4 est un graphe des signaux triangulaires utilisés dans un amplificateur numérique.

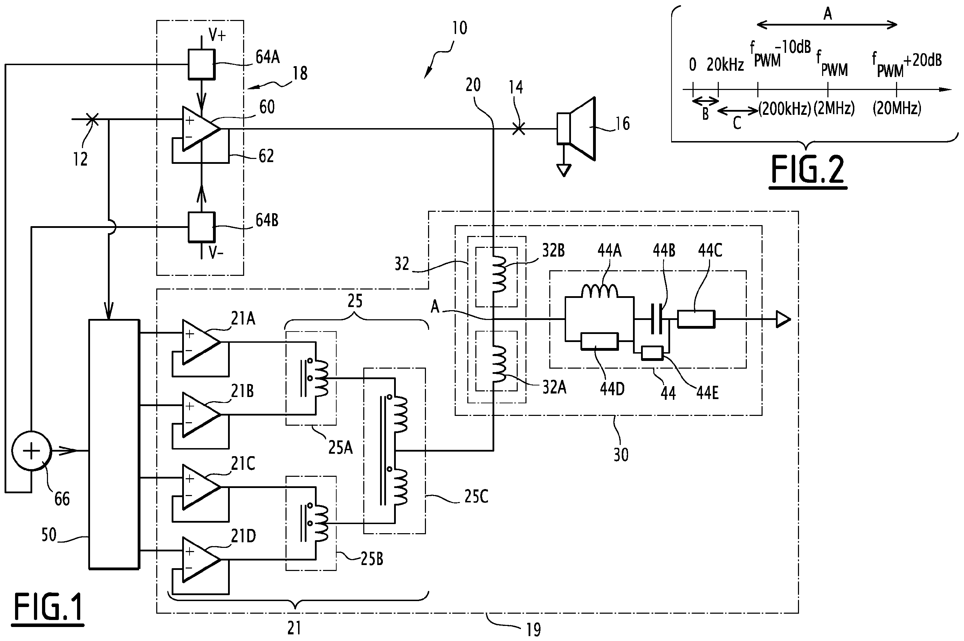

L'amplificateur audio 10 représenté sur la figure 1 comporte une entrée 12 propre à recevoir un signal audio analogique à amplifier $V_{in}$ et une sortie 14 de fourniture du signal amplifié à laquelle est reliée une charge formée d'un haut-parleur 16. Le haut-parleur 16 est relié directement, sans autre élément résistif, entre la sortie 14 de l'amplificateur et la masse.

L'entrée 12 de l'amplificateur est propre à recevoir une tension de commande dont la référence est la masse.

L'amplificateur 10 comporte un générateur de tension de référence 18 de très haute linéarité et de faible impédance de sortie formant un amplificateur class A et une source de courant de puissance 19 formant un amplificateur class D, dont les deux sorties sont couplées directement pour former la sortie 14 de l'amplificateur en un point de couplage 20.

La source de courant de puissance 19 comprend un générateur de tension de puissance 21 formé, d'une part, de quatre générateurs de tension de puissance élémentaires 21 A, 21B, 21C, 21D, dont les sorties sont reliées deux à deux par une chaine 25 d'autotransformateurs, et, d'autre part, d'une impédance de couplage 30 reliée en sortie de la chaine d'autotransformateurs et au travers de laquelle les générateurs de tension 21A, 21B, 21C, 21D sont accouplés au générateur de tension de référence 18. L'impédance de couplage 30 est formée principalement d'une inductance ayant une faible résistance.

L'entrée du générateur de tension de référence 18 est reliée à l'entrée 12 de l'amplificateur alors que la sortie de l'amplificateur de tension de référence 18 est reliée directement à la sortie 14 sans interposition d'aucun élément résistif, capacitif ou inductif.

Les sorties des générateurs de tension 18 et 21 sont reliées au point de couplage 20, au travers de l'impédance de couplage 30, laquelle est disposée entre la sortie de la chaine 25 d'autotransformateurs et le point de couplage 20.

Dans le mode de réalisation envisagé, l'impédance de couplage 30 comprend deux inductances 32A, 32B montées en série et dont le point milieu d'interconnexion est relié à la masse par une impédance d'atténuation 44.

La chaine d'autotransformateurs comporte deux autotransformateurs 25A, 25B, dont les deux entrées du primaire sont reliées respectivement aux sorties des générateurs de tension de puissance 21A, 21 B d'une part, et 21C, 21 D d'autre part. La sortie de chaque autotransformateur 25A, 25B, formée d'une dérivation à un point intermédiaire du primaire, est reliée à un troisième autotransformateur 25C, dont la sortie, constituant la sortie de la chaine d'autotransformateurs, est reliée à l'impédance de couplage 30.

La source de courant de puissance 19 est commandée par une unité de commande 50.

Le générateur de tension de référence 18 comporte un étage d'amplification de tension 60 schématisé par un amplificateur différentiel dont l'entrée non inverseuse est reliée directement à l'entrée 12 et dont l'entrée inverseuse est reliée à une boucle de contre-réaction 62 reliée directement à la sortie de l'amplificateur différentiel 60. De préférence, l'étage d'amplification en tension est formé, par exemple, d'un amplificateur opérationnel monté en suiveur en tension.

Le générateur 18 de tension de référence est un amplificateur de classe A ayant une très haute linéarité et une faible impédance de sortie. De préférence, l'impédance de sortie du générateur de tension de référence est inférieure à 0,2 Ohms.

L'amplificateur différentiel 60 est alimenté par deux tensions continues $V_+$ et $V_-$ et consomme un courant noté respectivement $I_+$ et $I_-$ sur chacune de ces entrées d'alimentation.

Des moyens de mesure du courant consommé 64A, 64B sont prévus sur chacune des entrées d'alimentation de l'amplificateur différentiel 60.

Ces moyens sont formés par exemple de détecteurs de courant comme décrits dans le document US 6 937 095. Ils sont propres à fournir une information représentative du courant fourni en sortie par le générateur de tension référence, le courant $i_A$ fourni par le générateur 18 étant directement lié au courant qu'il consomme.

Les sorties des capteurs de courant 64A, 64B sont reliées à un sommateur 66 dont la sortie fournit le courant $i_A$ consommé par le générateur de tension de référence et donc le courant fourni en sortie de ce même amplificateur. L'unité de commande 50 comporte notamment un régulateur linéaire non représenté recevant en entrée le courant $i_A$ en étant connecté en sortie du sommateur 66.

L'unité de commande 50 est connectée par une autre entrée, à l'entrée 12, pour recevoir le signal musical $V_{in}$ à amplifier.

Suivant un premier mode de réalisation, le régulateur est un régulateur proportionnel intégral (PI) intégrant seulement un étage d'amplification linéaire et un étage d'intégration sans étage de dérivation. En variante, le régulateur est un étage de type proportionnel intégral dérivé (PID) comportant les trois étages.

L'unité de commande 50 comporte quatre sorties produisant un même signal de commande déphasé de 90°. Chaque sortie est reliée à une entrée d'un générateur de tension de puissance 21A, 21B, 21C, 21D.

Ainsi, le générateur de courant de puissance 19 et donc chaque générateur de tension de puissance 21A, 21B, 21C, 21D sont propres à recevoir en entrée une combinaison du signal audio à amplifier $V_{in}$ issu de l'entrée 12 et une valeur représentative du courant $i_A$ consommé par le générateur de tension de référence 18.

Chaque générateur de tension de puissance 21A, 21B, 21C, 21 D est formé dans l'exemple considéré d'un amplificateur différentiel monté en suiveur, et dont l'entrée inverseuse est connectée directement à la sortie par une boucle de contre-réaction. Son entrée non inverseuse est reliée à une sortie de l'unité de commande 50.

Suivant un premier mode de réalisation, l'amplificateur différentiel monté en suiveur est constitué d'un amplificateur de classe D, c'est-à-dire d'un amplificateur de type « push/pull » comportant suivant sa branche d'amplificateur deux transistors « MOSFET » montés en anti-série, ces deux transistors étant pilotés suivant une loi de modulation par largeur d'impulsion, a une fréquence notée $f_{PWM}$ par exemple égale à 2MHz.

Suivant un autre mode de réalisation, chaque générateur de tension de puissance 20 est constitué d'un amplificateur de classe A ou de classe AB.

Avantageusement, l'impédance de couplage 30 a un module inférieur à dix fois le module de la charge, à savoir du haut-parleur 16, dans la gamme de fréquence utile.

Ainsi, par exemple pour un haut-parleur dont la résistance est de 4 Ohms, l'impédance 30 utilisée dans le cas d'un amplificateur de classe AB pour former le générateur de courant de puissance 19 est avantageusement inférieure à 5μH pour reproduire efficacement le spectre audio jusqu'à 20kHz. Alternativement, dans le cas d'un amplificateur destiné à un caisson de grave limité à 200Hz par exemple, la valeur de l'inductance peut atteindre 500μH.

La valeur totale de l'inductance formée des inductances 32A, 32B est comprise entre 0,1 μH et 1000μH. Leur résistance est très faible, avantageusement inférieure à 0,1Ω.

Les inductances 32A et 32B ont des valeurs d'impédance sensiblement égales et de préférence avec une différence de moins de 50%.

L'impédance d'atténuation 44 comporte avantageusement une inductance 44A. Dans le mode de réalisation, l'inductance 44A est montée en série, dans l'impédance d'atténuation 44, avec un condensateur 44B et une résistance 44C pour former un circuit RLC série. En outre, une résistance 44D est montée en parallèle de l'inductance 44A dans l'impédance d'atténuation 44. De même, avantageusement une résistance 44E est montée en parallèle du condensateur 44B. La résistance 44E est destinée à amortir les oscillations éventuelles aux bornes du condensateur 44B. La valeur de la résistance 44E est comprise entre 100 Ω, avantageusement elle est de 10kΩ.

La valeur $L_3$ de l'inductance 44A est très inférieure à la valeur individuelle notée $L_1$ et $L_2$ des deux inductances 32A et 32B.

De préférence, cette valeur de l'inductance 44A est inférieure au 10ème de la valeur des inductances 32A et 32B.

De plus, la valeur de la résistance 44DG est très supérieure à $|jL_3\omega|$ et de préférence supérieure à dix fois cette valeur où $L_3$ est la valeur de l'inductance 44A et $\omega$ est la pulsation du signal, ceci pour des valeurs de pulsation comprises entre $\frac{1}{10} \cdot 2\pi \cdot f_{PWM}$ et $10 \cdot 2\pi \cdot f_{PWM}$.

La valeur de la résistance 44C est très supérieure à $1/|jL_2\omega|$ et de préférence supérieure à 10 fois cette valeur où $L_2$ est la valeur minimale des inductances 32A et 32B et $\omega$ est la pulsation du signal, ceci pour des valeurs de pulsations inférieures à $\frac{1}{100} \cdot 2\pi \cdot f_{PWM}$.

La valeur de la résistance 44C est comprise entre 0,1 et 10Ω. Cette résistance est utilisée pour amortir les éventuelles oscillations des circuits résonnants LC constitués de l'inductance 44A et du condensateur 44B.

La capacité C du condensateur 44B est telle que le rapport à $1/|jC\omega|$ est très supérieur à l'impédance de la charge 16 et de préférence supérieure à 10 fois cette valeur où $\omega$ est la pulsation du signal inférieure à $\frac{1}{10} \cdot 2\pi \cdot f_{PWM}$.

La capacité C du condensateur 44B est telle que la valeur de son impédance le rapport $1/|jC\omega|$ est très inférieure à la valeur de l'impédance $|jL_3\omega|$ de 44A, la valeur $L_3$ de l'impédance 44A et de préférence inférieure au 10ème de cette valeur où $\omega$ est la pulsation du signal, ceci pour des valeurs de pulsation comprises entre $\frac{1}{10} \cdot 2\pi \cdot f_{PWM}$ et $10 \cdot 2\pi f_{PWM}$.

Suivant un premier mode de réalisation, l'impédance d'atténuation 44 ne comporte pas de résistance 44E placée en parallèle du condensateur 44B.

La valeur de la résistance 44D est comprise entre 10Ω et 1kΩ et est de préférence sensiblement égale à 100Ω.

Dans un tel montage, le ripple est réduit par la connexion de plusieurs amplificateurs classe D formé des générateurs de tension de puissance 21A, 21B, 21C, 21D, fonctionnant chacun avec un déphasage judicieusement choisi, ici de 90°, de manière à :

- annuler complètement de ripple haute fréquence pour certaines valeurs spécifiques de duty-cycle,
- via un couplage par autotransformeurs, faire un régulateur de type PWM multi-niveau qui revient, en ce qui concerne le ripple à diviser la tension d'alimentation par le nombre de phases, donc par conséquent, la valeur du courant de ripple,
- multiplier la fréquence du régulateur PWM résultant du coulage des phases par le nombre de phases couplées ; ainsi, coupler quatre phases à 400kHz équivaut à un régulateur PWM unique fonctionnant à 1,6 MHz.

Comme schématisé sur la figure 2, l'impédance d'atténuation 44, associée aux deux inductances 32A, 32B en série, se comporte comme :

- un atténuateur inductif de ratio au moins 1/5, ne présentant pas de déphasage significatif dans la bande de fréquence A commençant une décade en dessous de la fréquence $f_{PWM}$ de commutation du régulateur PWM de l'amplificateur classe D et s'étendant au moins une décade au-dessus de la fréquence de commutation du régulateur PWM de l'amplificateur classe D. Dans l'exemple considéré, la fréquence $f_{PWM}$ du régulateur PWM est de 2MHz (couplage de 4 phases à 500kHz déphasées de 90° chacune), et la fréquence $f_{PWM}$ - 10dB, un décade en dessous de la $f_{PWM}$, est égale à 200kHz alors que la fréquence $f_{PWM}$ + 20dB, deux décades au-dessus de $f_{PWM}$, est égale à 20MHz.
- un circuit Zobel tel que couramment utilisé pour stabiliser l'impédance de sortie des amplificateurs audio dans la bande audio notée B allant de 20Hz à 20kHz,
- un circuit bouchon fortement amorti, de faible facteur de qualité, à une fréquence située dans la bande C approximativement à mi-chemin entre la fréquence haute fréquence du spectre audio à reproduire égale à 20kHz et la fréquence de fonctionnement du régulateur PWM du classe D égale à 2MHz, à une fréquence sensiblement égale où il n'y a pas d'énergie à transmettre et où présenter une faible impédance n'a pas d'impact sur la dissipation de l'amplificateur analogique classe A.

Ainsi, par exemple, les valeurs suivantes satisfont aux relations exposées supra:

- inductances 32A, 32B de 25$\mu$H chacune,
- inductance 44A de 2,5$\mu$H
- résistance 44D de 100$\Omega$
- condensateur 44B de 100nF
- résistance 44E de 10k$\Omega$
- résistance 44C de 3$\Omega$

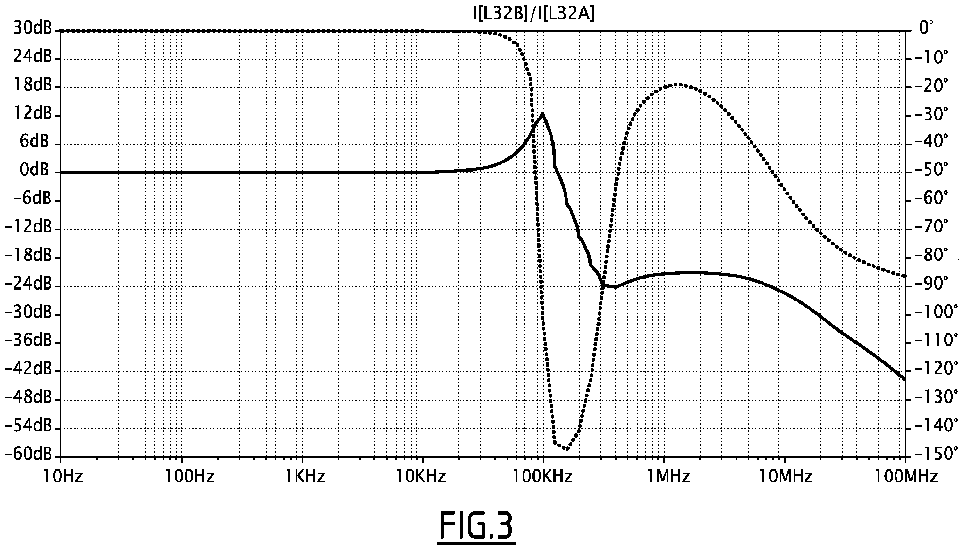

On obtient la fonction de transfert entre le courant dans les inductances 32A et 32B de la figure 3 représentant le gain et le déphasage entre les courants dans ces inductances.

Dans la bande audio (20Hz-20kHz), le courant dans l'inductance 32B est identique au courant dans l'inductance 32A, sans déphasage ; le circuit est assimilable uniquement aux inductances 32A et 32B en série, ce qui est souhaité, car tout le courant de l'amplificateur classe D est fourni à la charge 16.

Dans une bande de fréquence s'étendant entre 80kHz et 200kHz, le circuit présente une résonance amortie, la phase varie très fortement, mais il n'y a aucune énergie dans cette bande de fréquence, donc ce comportement n'est pas gênant. La fréquence de la résonance se situe légèrement au dessus de 100kHz, en dehors de la bande audio et plus d'une décade en dessous de la fréquence de fonctionnement du PWM, situé à 2MHz dans l'exemple.

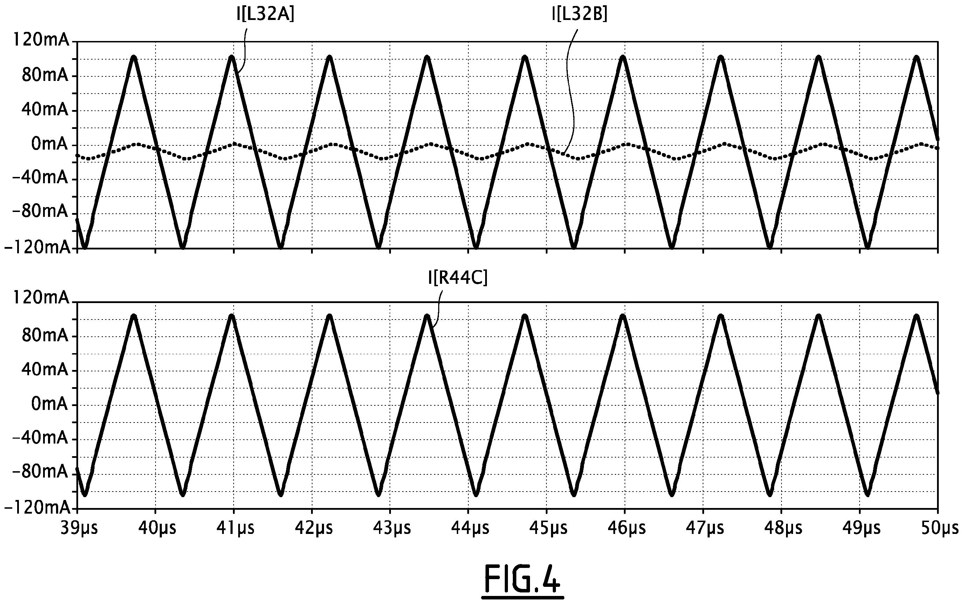

Dans une bande de fréquence s'étendant de 200kHz à 20MHz, le ratio des courants dans les inductances 32B et 32A est pratiquement constante (I(32B) = 0,1*I(32A). De 2MHz à 20MHz, la variation de phase est faible et quasiment linéaire en fréquence : le système se comporte alors comme un atténuateur constant doublé d'un retard pur, ce qui préserve la forme triangulaire des signaux utilisés dans l'asservissement, ainsi que le montre la figure 4 montrant les courants dans les inductances 32A, 32B et la résistance 44C.

On obtient alors le résultat désiré : le courant haute fréquence issu de l'amplificateur numérique classe D 19 est atténué de 20dB environ avant d'être couplé à l'amplificateur classe A 18, sans déformation significative du triangle de courant.

## Revendications

1. Amplificateur audio (10) comportant :

   - une entrée (12) pour un signal audio à amplifier ($V_{in}$) et une sortie (14) d'alimentation d'une charge (16) à partir du signal audio amplifié ;
   - un générateur (18) de tension de référence de haute linéarité et de faible impédance de sortie, propre à recevoir en entrée le signal audio à amplifier ($V_{in}$) ;
   - un générateur de courant (19) de puissance, comportant un générateur (21) de tension de puissance, dont la sortie est connectée à la sortie du générateur de tension de référence (18), au travers d'une impédance de couplage (30) ;

   l'impédance de couplage (30) comportant deux inductances de couplage (32A, 32B) montées en série entre la sortie du générateur de référence (18) et la sortie du générateur de tension de puissance (21) et une impédance d'atténuation (44) reliant un point milieu entre les deux inductances de couplage (32A, 32B) et un potentiel de référence, **caractérisé en ce que** l'impédance d'atténuation (44), associée aux deux inductances 32A, 32B en série, se comporte comme un atténuateur inductif et **en ce que** l'impédance d'atténuation (44) comporte une inductance d'atténuation (44A), dont la valeur ($L_3$) est inférieure au $10^{\text{ème}}$ de la valeur individuelle des inductances de couplage (32A, 32B).

2. Amplificateur selon l'une quelconque des revendications précédentes, **caractérisé en ce que** l'impédance d'atténuation (44) comporte un condensateur (44B) monté en série avec l'inductance d'atténuation (44A).

3.  Amplificateur selon la revendication 2, **caractérisé en ce que** la capacité C du condensateur (44B) est telle que le rapport à 1/|jCω| est très inférieur à la valeur |jL_3ω| de l'impédance d'atténuation (44A) d'inductance L_3 et de préférence inférieure au 10^{ème} de cette valeur, où ω est la pulsation du signal, ceci pour des valeurs de pulsation comprises entre

$$\frac{1}{10} \cdot 2\pi \cdot f_{PWM}$$ et $10 \cdot 2\pi f_{PWM}$, $f_{PWM}$ étant la fréquence fondamentale d'un triangle de courant dans l'inductance de couplage (32A).

4.  Amplificateur selon la revendication 3, **caractérisé en ce que** la capacité C du condensateur (44B) est telle que le rapport à 1/|jCω| est supérieur à l'impédance de la charge (16) et de préférence supérieur à 10 fois cette valeur, où ω est la pulsation du signal inférieure à $\frac{1}{10} \cdot 2\pi \cdot f_{PWM}$ , $f_{PWM}$ étant la fréquence fondamentale d'un triangle de courant dans l'inductance de couplage (32A).

5.  Amplificateur selon l'une quelconque des revendications précédentes, **caractérisé en ce que** l'impédance d'atténuation (44) comporte une résistance (44C) montée en série avec l'inductance d'atténuation (44A).

6.  Amplificateur selon la revendication 5, **caractérisé en ce que** la valeur de la résistance (44C) est supérieure à |jL_2ω| et de préférence supérieure à 10 fois cette valeur, où L_2 est la valeur minimale des l'inductances de couplage (32B) et ω est la pulsation du signal, ceci pour des valeurs de pulsation inférieures à $\frac{1}{100} \cdot 2\pi \cdot f_{PWM}$, $f_{PWM}$ étant la fréquence fondamentale d'un triangle de courant dans l'inductance de couplage (32A).

7.  Amplificateur selon l'une quelconque des revendications 2 à 4 d'une part, et l'une quelconque des revendications 5 et 6 d'autre part, **caractérisé en ce que** l'impédance d'atténuation (44) est un circuit RLC.

8.  Amplificateur selon l'une quelconque des revendications précédentes, **caractérisé en ce que** l'impédance d'atténuation (44) comporte une résistance (44D) montée en parallèle avec l'inductance d'atténuation (44A).

9.  Amplificateur selon la revendication 8, **caractérisé en ce que** la valeur de la résistance (44D) est très supérieure à |jL_3ω| et de préférence supérieure à dix fois cette valeur où L_3 est la valeur de l'inductance (44A) et ω est la pulsation du signal, ceci pour des valeurs de pulsation comprises entre

$$\frac{1}{10} \cdot 2\pi \cdot f_{PWM}$$ et $10 \cdot 2\pi \cdot f_{PWM}$, $f_{PWM}$ étant la fréquence fondamentale d'un triangle de courant dans l'inductance de couplage (32A).

10. Amplificateur selon l'une quelconque des revendications précédentes, **caractérisé en ce que** l'impédance d'atténuation (44) comporte une résistance (44E) montée en parallèle avec le condensateur (44B).

11. Amplificateur selon l'une quelconque des revendications précédentes, caractérisé en que le générateur de courant de puissance (19) comporte plusieurs générateurs de tension de puissance (21A, 21B, 21C, 21D) recevant en entrée des mêmes signaux déphasés et en ce qu'il comporte au moins un autotransformateur (25A, 25B, 25C) reliant entre elles les sorties des générateurs de tension de puissance (21A, 21B, 21C, 21D) et dont la sortie est reliée à l'impédance de couplage (30).

**Patentansprüche**

1.  Audioverstärker (10), aufweisend:

    - einen Eingang (12) für ein zu verstärkendes Audiosignal ($V_{in}$) und einen Ausgang (14) zur Speisung einer Last (16) aus dem verstärkten Audiosignal;
    - einen Referenzspannungsgenerator (18) hoher Linearität und niedriger Ausgangsimpedanz, der ausgebildet ist, am Eingang das zu verstärkende Signal ($V_{in}$) zu empfangen;
    - einen Leistungsstromgenerator (19), der einen Leistungsspannungsgenerator (21) aufweist, dessen Ausgang mit dem Ausgang des Referenzspannungsgenerators (18) über eine Koppelimpedanz (30) verbunden ist;

    wobei die Koppelimpedanz (30) zwei Koppelinduktivitäten (32A, 32B), die zwischen dem Ausgang des Referenzgenerators (18) und dem Ausgang des Leistungsspannungsgenerators (21) in Reihe geschaltet sind, und eine Dämpfungsimpedanz (44) aufweist, die einen Mittelpunkt zwischen den zwei Koppelinduktivitäten (32A, 32B) mit einem Referenzpotential verbindet,
    **dadurch gekennzeichnet, dass** die Dämpfungsimpedanz (44), die den zwei in Reihe liegenden Induktivitäten (32A, 32B) zugeordnet ist, sich wie ein induktives Dämpfungselement verhält und dass die Dämpfungsimpedanz (44) eine Dämpfungsinduktivität (44A) aufweist, deren Wert ($L_3$) kleiner als ein Zehntel des individuellen Wertes der Koppelinduktivitäten (32A, 32B) ist.

2. Verstärker nach einem beliebigen der vorhergehenden Ansprüche, **dadurch gekennzeichnet, dass** die Dämpfungsimpedanz (44) einen Kondensator (44B) aufweist, der in Reihe mit der Dämpfungsinduktivität (44A) geschaltet ist.

3. Verstärker nach Anspruch 2, **dadurch gekennzeichnet, dass** die Kapazität C des Kondensators (44B) derart ist, dass das Verhältnis bei $1/|jCw|$ sehr viel kleiner als der Wert $|jL_3\omega|$ der Dämpfungsimpedanz (44A) der Induktivität $L_3$ und vorzugsweise kleiner als ein Zehntel dieses Wertes ist, wobei $\omega$ die Kreisfrequenz des Signals ist, wobei dies für Kreisfrequenzwerte zwischen $1/10 \cdot 2\pi \cdot f_{PWM}$ und $10 \cdot 2\pi \cdot f_{PWM}$ gilt, wobei $f_{PWM}$ die Grundfrequenz eines Stromdreiecks in der Koppelinduktivität (32A) ist.

4. Verstärker nach Anspruch 3, **dadurch gekennzeichnet, dass** die Kapazität C des Kondensators (44B) derart ist, dass das Verhältnis bei $1/|C\omega|$ größer als die Lastimpedanz (16) und vorzugsweise größer als das 10 fache dieses Wertes ist, wobei $\omega$ die Kreisfrequenz des Signals kleiner als $1/10 \cdot 2\pi \cdot f_{PWM}$ ist, wobei $f_{PWM}$ die Grundfrequenz eines Stromdreiecks in der Koppelinduktivität (32A) ist.

5. Verstärker nach einem beliebigen der vorhergehenden Ansprüche, **dadurch gekennzeichnet, dass** die Dämpfungsimpedanz (44) einen Widerstand (44C) aufweist, der in Reihe mit der Dämpfungsinduktivität (44A) geschaltet ist.

6. Verstärker nach Anspruch 5, **dadurch gekennzeichnet, dass** der Wert des Widerstandes (44C) größer als $|jL_2\omega|$ ist und vorzugsweise größer als das 10fache dieses Wertes ist, wobei $L_2$ der Minimalwert der Koppelinduktivitäten (32B) ist und $\omega$ die Kreisfrequenz des Signals ist, wobei dies für Kreisfrequenzwerte kleiner als $1/100 \cdot 2\pi \cdot f_{PWM}$ gilt, wobei $\cdot f_{PWM}$ die Grundfrequenz eines Stromdreiecks in der Koppelinduktivität (32A) ist.

7. Verstärker nach einem beliebigen der Ansprüche 2 bis 4 einerseits und einem beliebigen der Ansprüche 5 und 6 andererseits, **dadurch gekennzeichnet, dass** die Dämpfungsimpedanz (44) ein RLC Kreis ist.

8. Verstärker nach einem beliebigen der vorhergehenden Ansprüche, **dadurch gekennzeichnet, dass** die Dämpfungsimpedanz (44) einen Widerstand (44D) aufweist, der parallel zur Dämpfungsinduktivität (44A) geschaltet ist.

9. Verstärker nach Anspruch 8, **dadurch gekennzeichnet, dass** der Wert des Widerstandes (44D) sehr viel größer als $|jL_3\omega|$ und vorzugsweise größer als 10 mal dieses Wertes ist, wobei $L_3$ der Wert der Induktivität (44A) ist und $\omega$ die Kreisfrequenz des Signals ist, wobei dies für Kreisfrequenzwerte zwischen $1/10 \cdot 2\pi \cdot f_{PWM}$ und $10 \cdot 2\pi \cdot f_{PWM}$ gilt, wobei $f_{PWM}$ die Grundfrequenz eines Stromdreiecks in der Koppelinduktivität (32A) ist.

10. Verstärker nach einem beliebigen der vorhergehenden Ansprüche, **dadurch gekennzeichnet, dass** die Dämpfungsimpedanz (44) einen Widerstand (44E) aufweist, der parallel zum Kondensator (44B) geschaltet ist.

11. Verstärker nach einem beliebigen der vorhergehenden Ansprüche, **dadurch gekennzeichnet, dass** der Leistungsstromgenerator (19) mehrere Leistungsspannungsgeneratoren (21A, 21B, 21C, 21D) aufweist, die am Eingang gleiche phasenverschobene Signale erhalten und dass er mindestens einen Spartransformator (25A, 25B, 25C) aufweist, der die Ausgänge der Leistungsspannungsgeneratoren (21A, 21B, 21C, 21D) untereinander verbindet und dessen Ausgang mit der Koppelimpedanz (30) verbunden ist.

**Claims**

1. An audio amplifier (10), including:

 - an input (12) for an audio signal to be amplified ($V_{in}$) and an output (14) for powering a load (16) on the basis of the amplified audio signal;
 - a generator (18) of reference voltage of high linearity and low output impedance, able to receive, as input, the audio signal to be amplified ($V_{in}$);
 - a power current generator (19) including a power voltage generator (21) whose output is connected to the output of the reference voltage generator (18) through a coupling impedance (30);

 the coupling impedance (30) including two coupling inductances (32A, 32B) mounted in series between the output of the reference generator (18) and the output of the power voltage generator (21) and an attenuation impedance (44) linking a mid-point between the two coupling inductances (32A, 32B) and a reference potential, **characterized in that** the attenuation impedance (44), associated with the two inductances (32A, 32B) in series, behaves like an inductive attenuator and **in that** the attenuation impedance (44) includes an attenuation inductance (44A), the value of which is less than 1/10$^{th}$ of the individual value of the coupling inductances (32A, 32B).

2. The amplifier according to claim 1, **characterized in that** the attenuation impedance (44) includes a capacitor (44B) mounted in series with the attenuation inductance (44A).

3. The amplifier according to claim 2, **characterized in that** the capacity C of the capacitor (44B) is such that the ratio at 1/|jCω| is much lower than the value |jL$_3$| of the inductance attenuation impedance (44A) L$_3$ and preferably less than 1/10$^{th}$ of this value, where ω is the angular frequency of the signal, for angular frequency values comprised between

$$\frac{1}{10} \cdot 2\pi \cdot f_{PWM} \text{ and } 10 \cdot 2\pi \cdot f_{PWM}, f_{PWM} \text{ being}$$

the fundamental frequency of a current ripple in the coupling inductance (32A).

4. The amplifier according to claim 3, **characterized in that** the capacity C of the capacitor (44B) is such that the ratio at 1/|jCω| is greater than the impedance of the load (16) and preferably more than 10 times this value, where ω is the angular frequency of the signal less than $\frac{1}{10} \cdot 2\pi \cdot f_{PWM}$ , f$_{PWM}$ being the fundamental frequency of a current ripple in the coupling inductance (32A).

5. The amplifier according to any one of the preceding claims, **characterized in that** the attenuation impedance (44) includes a resistance (44C) mounted in series with the attenuation inductance (44A).

6. The amplifier according to claim 5, **characterized in that** the value of the resistance (44C) is greater than |jL$_2$ω| and preferably more than 10 times this value, where L$_2$ is the minimum value ef the coupling inductance (32B) and ω is the angular frequency of the signal, for angular frequency values below

$$\frac{1}{100} \cdot 2\pi \cdot f_{PWM}, f_{PWM} \text{ being the fundamental}$$

frequency of a current ripple in the coupling inductance (32A).

7. The amplifier according to any one of claims 2 to 4 on the one hand, and any one of claims 7 and 8 on the other hand, **characterized in that** the attenuation impedance (44) is a RLC circuit.

8. The amplifier according to any one of the preceding claims, **characterized in that** the attenuation impedance (44) includes a resistance (44D) mounted in parallel with the attenuation inductance (44A).

9. The amplifier according to claim 8, **characterized in that** the value of the resistance (44D) is significantly greater than |jL$_3$| and preferably greater than ten times this value, where L$_3$ is the value of the inductance (44A) and ω is the angular frequency of the signal, for angular frequency values comprised between $\frac{1}{10} \cdot 2\pi \cdot f_{PWM}$ and $10 \cdot 2\pi \cdot f_{PWM}$, f$_{PWM}$ being the fundamental frequency of a current ripple in the coupling inductance (32A).

10. The amplifier according to any one of the preceding claims, **characterized in that** the attenuation impedance (44) includes a resistance (44E) mounted in parallel with the capacitor (44B).

11. The amplifier according to any one of the preceding claims, **characterized in that** the power current generator (19) includes several power voltage generators (21A, 21B, 21C, 21D) receiving, as input, the same phase-shifted signals and at least one autotransformer (25A, 25B, 25C) connecting the outputs of the power voltage generators (21A, 21B, 21C, 21D) to one another and whose output is connected to the coupling impedance (30).

FIG.1

FIG.2

I[L32B]/I[L32A]

EP 3 161 958 B1

FIG.3

FIG.4

## RÉFÉRENCES CITÉES DANS LA DESCRIPTION

**Documents brevets cités dans la description**

- WO 2011107669 A
- WO 2004057754 A
- FR 2828582 A1
- JP S57171809 B
- US 6937095 B

**Littérature non-brevet citée dans la description**

- **NAM-IN KIM et al.** Ripple feedback filter suitable for analog/digital mixed-mode audio amplifier for improved efficiency and stability. *POWER ELECTRONICS SPECIALISTS CONFERENCE; [ANNUAL POWER ELECTRONICS SPECIALISTS CONFERENCE,* 23 Juin 2002, vol. 1, ISBN 978-0-7803-7262-7, 45-49